# EUROPEAN PATENT SPECIFICATION

(11) **EP 1 371 746 B1**
(45) Date of publication and mention of the grant of the patent: **22.03.2006**
(21) Application number: 02710513.9
(22) Date of filing: 05.02.2002
(51) Int. Cl.: C23C 14/28, C23C 14/50, C23C 14/56

(54) **FILM FORMING METHOD AND FILM FORMING DEVICE**
VERFAHREN UND VORRICHTUNG ZUR HERSTELLUNG VON FILMEN
PROCEDE FILMOGENE ET DISPOSITIF FILMOGENE

(30) Priority: 08.02.2001 JP 2001032280
(43) Date of publication of application: 17.12.2003
(73) Proprietor: Sumitomo Electric Industries, Ltd., Osaka-shi, Osaka 541-0041 (JP)
(72) Inventor: HAHAKURA,Sc/o Osaka Works ofSumitomo Elect Ind Ltd, Osaka-shi, Osaka 554-8511 (JP); OHMATSU,Kc/o Osaka Works of Sumitomo Elect Ind Ltd, Osaka-shi, Osaka 554-8511 (JP)
(74) Representative: Kreutzer, Ulrich
(86) International application number: PCT/JP2002/000936
(87) International publication number: WO 2002/063063

(56) References cited:
- JP-A- 5 033 124
- JP-A- 6 101 037
- JP-A- 6 145 977
- JP-A- 8 144 051
- JP-A- 11 086 647
- JP-A- 2000 319 096
- US-A- 4 412 507
- US-A- 4 601 912
- PATENT ABSTRACTS OF JAPAN vol. 018, no. 680 (C-1291), 21 December 1994 (1994-12-21) & JP 06 271394 A (CHODENDO HATSUDEN KANREN KIKI ZAIRYO GIJUTSU KENKYU KUMIAI), 27 September 1994 (1994-09-27)
- LEE S-G ET AL: "DEPOSITION ANGLE-DEPENDENT MORPHOLOGY OF LASER DEPOSITED YBA2CU3O7 THIN FILMS" APPLIED PHYSICS LETTERS, AMERICAN INSTITUTE OF PHYSICS. NEW YORK, US, vol. 65, no. 6, 8 August 1994 (1994-08-08), pages 764-766, XP000464593 ISSN: 0003-6951

## Description

### Technical Field

The present invention relates to a film deposition method and a film deposition apparatus, and more particularly to a film deposition method and a film deposition apparatus allowing deposition for a substrate having a large area.

### Background Art

Laser ablation has conventionally been known as one of techniques of forming an oxide superconductor thin film. Here, the laser ablation is a technique of forming a prescribed thin film by irradiating a surface of a solid body such as a target material with intensive laser light to locally heat the solid body, thereby scattering atoms or ions from the solid body surface into the air, and depositing these scattered atoms and the like on a surface of another body. The conventional deposition method using such laser ablation includes, for example, a film deposition method as disclosed in Japanese Patent Laying-Open No. 8-246136.

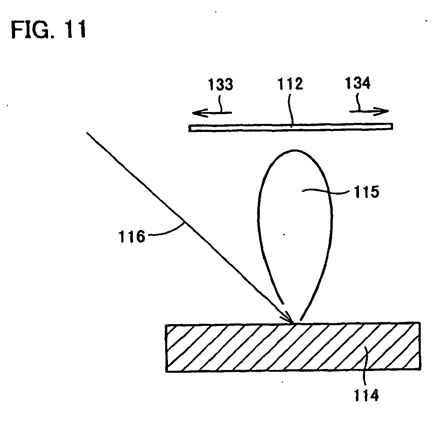

Fig. 11 is a schematic view illustrating the conventional deposition method disclosed in Japanese Patent Laying-Open No. 8-246136. Referring to Fig. 11, the conventional deposition method will be described.

Referring to Fig. 11, in the conventional deposition method, a substrate 112 is arranged to be opposed to a target material 114 that is to be irradiated with laser light 116. The surface of substrate 112 is approximately parallel to the surface of target material 114. Then, irradiation of the surface of target material 114 with laser light 116 causes target material 114 to be locally heated. A plume 115 is formed of the atoms and the like scattered from the heated part of target material 114. The atoms and the like that form plume 115 are deposited on the surface of substrate 112 that is opposed to plume 115, resulting in an oxide superconductor thin film. The deposition rate in substrate 112 is greater at a region closer to the center of plume 115. Therefore, according to the deposition method shown in Fig. 11, a thin film having an approximately uniform film thickness over the entire substrate 112 can be formed by moving substrate 112 in the direction as indicated by the arrows 113 and 114 and the direction vertical to the plane of the drawing.

The conventional deposition method as described above, however, has the problem described below.

When the usage and manufacturing processes of oxide superconductors, or the like require that substrate 112 on which a thin film is formed should be increased in size, in the deposition method shown in Fig. 11, substrate 112, when excessively increased in size, would block laser light 116 incident on target material 114. Therefore, the conventional film deposition method shown in Fig. 11 has its limits in increasing the size of substrate 112.

US 4,601,912 describes a method for preparing a magnetic recording medium employing an apparatus in which a web is delivered from a roll, transported by a drum and taken up by another roll. When in contact with the drum the web is coated with a ferromagnetic material, which has been evaporated from a boat by an e-beam.
During coating the surface of the web forms a certain angle with respect to the surface of the material in the boat. The angle is determined by the surface of the evaporation material and the tangent at the surface of the web at any position between two masking shields.

In JP 11 086 647 a tape-like base material is coated, first, with an intermediate thin film, then with an antidiffusion layer, such as Y₂O₃ or CeO₂, and, finally, an oxide superconducting film is deposited.
The target materials are evaporated by a laser beam. The surface of the target and the surface of the tape form an acute angle. The laser beam has a direction parallel to the surface of the tape.

JP 06 101 037 teaches an apparatus comprising a target, which is evaporated by an ion beam, a substrate holder, a motor within the substrate holder and an arm which has an arc-shaped section. The arc-shaped section allows the holder to be shifted into different positions so that the angle between the surface of the substrate and the surface of the target can be varied.

In Appl. Phys. Lett. 65 (6), 1994, page 764, S.-G. Lee et al. examine the effects on the film properties of the angle between the surface of the substrate and the surface of the target, if a film of YBa₂Cu₃O₇ is deposited on a substrate through laser ablation from a target. Angles have been varied between 0 - 90°.

An object of the present invention is to provide a film deposition method and a film deposition apparatus capable of forming a film on a substrate having a large area.

### Disclosure of the Invention

This object is achieved by providing a coating method according to claim 1 or claim 2 and by providing an apparatus according to claim 13.

Here, consider the target material is irradiated with energy rays such as laser light in order to scatter the deposition material from the surface of the target material. These energy rays are applied in an oblique direction with respect to the surface of the target material. When the substrate and the target material are arranged such that the surface of the substrate forms an angle to the surface of the target material, the substrate can be arranged such that the surface of the substrate has approximately the same direction as a path of these energy rays. This can prevent the interference of the substrate with the path of the energy ray, even when the substrate is increased in size. Therefore, a film can be formed on a larger substrate without the constraints of the path of energy rays.

Furthermore, since the relative position of the substrate with respect to the target material is moved in the direction of the length of the substrate and in the direction of the width of the substrate in forming a film on the substrate, it is possible to form a film uniformly over the entire substrate.

In the film deposition method in accordance with one aspect described above, preferably, the angle between the surface of the substrate and the surface of the target material exceeds 0° and is equal to or less than 90°.

In this case, the angle between the surface of the substrate and the surface of the target material exceeding 0° ensures that the substrate can be arranged to be inclined to the target material. Furthermore, as described above, the radiation direction of energy rays to the surface of the target material and the inclination direction of the substrate are the same, thereby preventing the substrate from blocking the path of energy rays when the substrate having a size larger than the conventional one is used.

In addition, the angle between the surface of the substrate and the surface of the target material of 90° or less ensures that the deposition material scattered from the surface of the target material can reach the surface of the substrate on which a film is to be formed. As a result, a film can be formed on the substrate reliably.

In the film deposition method in accordance with one aspect as described above, the energy rays may be applied to the surface of the target material in order to scatter the deposition material from the target material surface.

As described above, the present invention can prevent the interference between the path of energy rays and the substrate. Therefore, the present invention is particularly effective where a substrate is increased in size, in a film deposition method using energy rays to scatter a deposition material from a target material.

In the film deposition method in accordance with one aspect as described above, the angle between the path of energy rays and the surface of the target material may be smaller than the angle between the surface of the substrate and the surface of the target material.

In this case, the angle between the surface of the substrate and the surface of the target material (an inclination angle of the substrate) is larger than the angle of the path of energy rays to the surface of the target material (an incident angle of energy rays). Therefore, the inclination of the substrate in the same direction as the incident direction of energy rays can surely prevent the interference of the substrate with the path of energy rays on that surface side of the target material which is irradiated with the energy rays. As a result, the target material surface is irradiated with the energy rays reliably, with the substrate larger than the conventional one. Therefore, a film is reliably formed on the surface of the substrate having a large area.

In the film deposition method in accordance with one aspect as described above, the path of energy rays is approximately parallel to the surface of the substrate.

In this case, with a substrate of any larger size, the substrate does not interfere with the path of energy rays. Therefore, a film can be formed on the surface of a substrate of any size.

The film deposition method in accordance with one aspect as described above may further include an angle varying step of changing an angle between the surface of the substrate and the surface of the target material by varying a relative position of the substrate with respect to the target material.

In this case, the angle between the surface of the substrate and the surface of the target material (the inclination angle) can be varied arbitrarily. Here, it is possible to vary arbitrarily the deposition conditions such as a deposition rate on the substrate surface or a film property such as a density of particles in the formed film by varying the inclination angle. Therefore, it becomes possible to select the deposition conditions in accordance with the property of the formed flm.

In the film deposition method in accordance with the invention in the deposition step, a moving direction in which the relative position of the substrate with respect to the target material is moved is approximately parallel to the surface of the substrate.

Therefore the position of the substrate with respect to the target material can be moved with the angle of the surface of the substrate to the surface of the target material being always kept constant. Therefore, it is possible to keep the deposition conditions constant over the entire surface of the substrate on which a film is formed (a deposition surface of the substrate). As a result, a uniform film can readily be formed over the entire deposition surface of the substrate.

In the film deposition method in accordance with one aspect as described above, the film may include an oxide superconductor.

When the present invention is applied to a process of forming an oxide superconductor film, in this way, a uniform oxide superconductor film can be formed on the surface of the substrate of larger size. Since the film uniformity is one of the particularly important features in the oxide superconductor film, the present invention is suitable specifically for the process of manufacturing an oxide superconductor film.

In the film deposition method in accordance with one aspect as described above, preferably, the oxide superconductor includes at least one kind selected from the group consisting of an RE 123-based oxide superconductor and a bismuth-based oxide superconductor.

Here, the RE123-based oxide superconductor refers to a superconductor as approximately represented by REBa₂Cu₃Oₓ, and RE refers to a rare-earth element such as yttrium (Y), or neodymium (Nd), samarium (Sm), holmium (Ho). As the bismuth=based oxide superconductor, preferably used is an oxide superconductor essentially including 2223 phase, that is, a phase as approximately represented by (BixPb ₁₋ₓ )₂Sr₂Ca₂Cu₃O_{Y}.

By applying the present invention to a process of manufacturing these oxide superconductors, it is possible to readily form a uniform film of the RE123-based oxide superconductor and the bismuth-based oxide superconductor.

The film deposition method in accordance with one aspect as described above may further include a step of forming an oxide superconductor on a film. This film may be an intermediate film positioned between the substrate and the oxide superconductor.

Conventionally, an intermediate film is formed as an intermediate layer between a substrate and an oxide superconductor in order to maintain the good property of the oxide superconductor formed on the substrate. In order to make the property of the oxide superconductor uniform over the entire surface of the substrate, this intermediate film also need to have a uniform film thickness or property over the entire surface of the substrate. By applying the present invention to the process of manufacturing such an intermediate film, a uniform intermediate film can readily be formed. As a result, the property of the oxide superconductor can be made uniform over the entire surface of the substrate.

In the film deposition method in accordance with one aspect as described above, the film may include at least one kind selected from the group consisting of yttria-stabilized zirconia, cerium oxide, magnesium oxide, and strontium titanate.

Yttria-stabilized zirconia and the like as described above exhibit an excellent property as an intermediate film. By applying the present invention to the process of manufacturing a film suitable for such an intermediate film, an intermediate film having an excellent film property can readily be obtained.

In the film deposition method in accordance with one aspect as described above, a material forming the substrate may include at least one selected from the group consisting of sapphire, lanthanum aluminate, strontium titanate, LASAT (Lanthanum Strontium Aluminum Titanium Oxide).

The substrate made of sapphire as described above is in conformity in lattice with the oxide superconductor and the intermediate film. Therefore, using a substrate made of the material described above to form an oxide superconductor and an intermediate film by the film deposition method of the present invention results in an oxide superconductor or an intermediate layer with a uniform and excellent film property.

In a film deposition apparatus in accordance with the present invention, a thin film is formed by scattering a deposition material from a surface of a target material and depositing the scattered deposition material onto a surface of a substrate. The film deposition apparatus includes varying means for varying an angle of the surface of the substrate to the surface of the target material.

In this way, a film deposition step can be carried out using the film deposition apparatus in accordance with the present invention, with an angle of the surface of the substrate with respect to the surface of the target material (an inclination angle) being set to an arbitrary angle. The deposition condition such as a deposition rate on a substrate can be varied by varying the inclination angle. Therefore, the deposition conditions can be arbitrarily varied to be adapted to the property of the formed film by varying the inclination angle.

Here, consider the target material is irradiated with energy rays such as laser light in order to scatter a deposition material from the surface of the target material. The energy rays are usually applied in an oblique direction with respect to the surface of the target material. When the varying means is used to determine the inclination angle such that the surface of the substrate forms an angle with respect to the surface of the target material, the substrate is arranged such that the surface of the substrate has approximately the same direction as a path of the energy rays. This can prevent interference of the substrate with the path of energy rays, even with a substrate increased in size. Therefore, a film can be formed on a larger substrate without the constraints of the path of energy rays.

The apparatus according to the invention also comprises moving means for moving a relative position of said substrate with respect to said target in the direction approximately parallel to the surface of said substrate, the moving means being capable of moving the substrate's position relative to the target material in the directions of the width and length of said substrate.

In the film deposition apparatus in accordance with another aspect as described above, the varying means may include an arc-shaped guide member and a substrate holding member movably mounted to the guide member for holding a substrate.

In this case, the inclination angle can easily be varied by moving the substrate holding member holding the substrate along the guide member. By using the moving means to move the substrate relative to the target material, the deposition material scattered from the target material can be deposited uniformly over the entire surface of the substrate. As a result, a film can be formed uniformly over the entire surface of the substrate.

The position of the substrate with respect to the target material is moved with the angle of the surface of the substrate to the surface of the target material being always kept constant. Therefore, it is possible to keep the deposition conditions constant over the entire surface of the substrate on which a film is to be formed (a deposition surface of the substrate). As a result, a uniform film can readily be formed over the entire deposition surface of the substrate.

The film deposition apparatus in accordance with another aspect as described above may further include irradiation means for irradiating the target material surface with energy rays in order to scatter the deposition material from the target material surface.

As described above, in accordance with the present invention, the interference between the path of energy rays and the substrate can be prevented by using the varying means to vary the inclination angle of the substrate so that the incident direction of energy rays and the inclination direction of the substrate to the target material are aligned. Therefore, it is possible to increase the substrate size in the film deposition apparatus having irradiation means for irradiating the target material with energy rays for scattering a deposition material therefrom.

### Brief Description of the Drawings

Fig. 1 is a schematic view showing an embodiment of a film deposition apparatus
Fig. 2 is a block diagram showing a configuration of the film deposition apparatus shown in Fig. 1.
Fig. 3 is a schematic view illustrating a first exemplary film deposition method using the film deposition apparatus shown in Figs. 1 and 2.
Fig. 4 is a schematic view illustrating a second exemplary film deposition method using the film deposition apparatus shown in Figs. 1 and 2.
Fig. 5 is a schematic view illustrating a third exemplary film deposition method using the film deposition apparatus shown in Figs.1 and 2.
Fig. 6 is a schematic view illustrating a fourth exemplary film deposition method using the film deposition apparatus shown in Figs. 1 and 2.
Fig. 7 is a schematic diagram illustrating a moving method according to the invention where a substrate is moved relative to a target material.
Fig. 8 is a schematic diagram illustrating a moving method according to the invention where a substrate is moved relative to a target material.
Fig. 9 is a schematic diagram illustrating a moving method according to the invention where a substrate is moved relative to a target material.
Fig. 10 is a schematic view illustrating an arrangement of a substrate and a target material in a film deposition step in Example 2.
Fig. 11 is a schematic view illustrating another conventional film deposition method.

### Best Modes for Carrying Out the Invention

In the following, embodiments and examples of the present invention will be described based on the figures. It is noted that in the following figures the same or corresponding parts will be denoted with the same reference numerals and descriptions thereof will not be repeated.

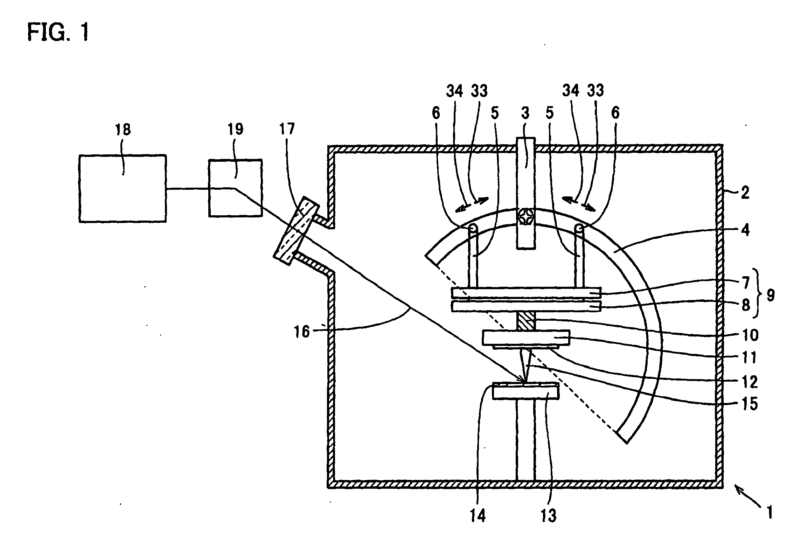

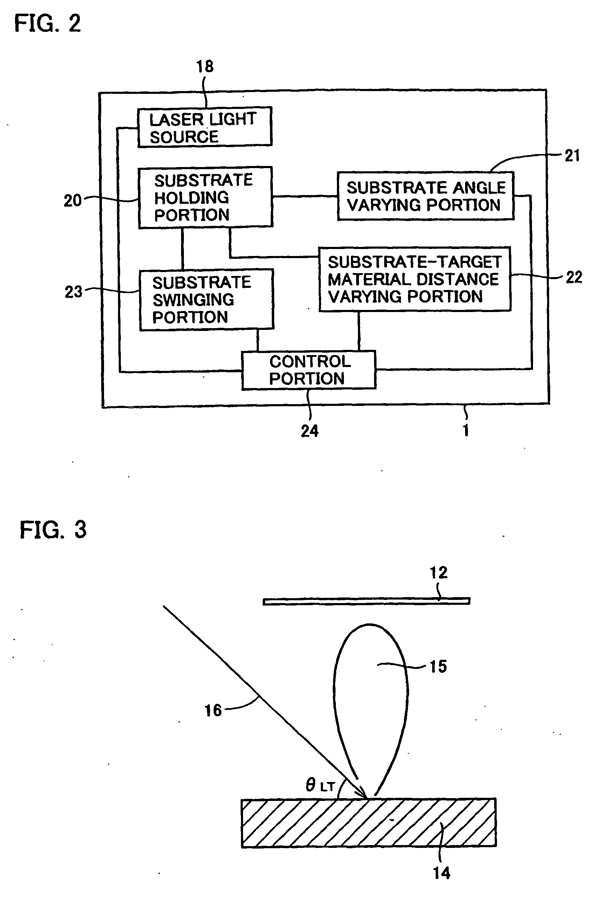

Referring to Figs. 1 and 2, a film deposition apparatus 1 includes a chamber 2 as a processing room, a target stage 13 arranged within chamber 2, an arc-shaped guide 4, an XY stage 9 movably attached to arc-shaped guide 4, a substrate stage 11 as a substrate holding member mounted to XY stage 9, a laser light source 18 for irradiating a target material 14 arranged on a target stage 13 with laser light 16, and an optical system 19 for use in determining an optical axis of laser light 16 with which target material 14 is irradiated. In chamber 2, target stage 13 is arranged as described above, and target material 14 is mounted on target stage 13. Target stage 13 can be moved upward and downward. Within chamber 2, above the target stage 13, arch-shaped guide 4 is provided, which is fixed to chamber 2 by means of a support member 3. Arc-shaped guide 4 is provided with XY stage 9 by means of a support member 5. A guide connection portion 6, which is a connection portion between support member 5 and arc-shaped guide 4, is connected such that it can be moved through arc-shaped guide 4 in the direction as indicated by the arrows 33 and 34 in Fig. 1. Therefore, XY stage 9 can be moved along arc-shaped guide 4.

XY stage 9 includes a stage base 7 connected to support member 5, and a stage moving portion 8 connected to stage base 7. Stage moving portion 8 is movable relative to stage base 7 in a direction approximately parallel to the surface of stage base 7. Movement of stage moving portion 8 is effected by driving means such as a stepping motor (not shown) mounted on stage base 7. Under the control of the driving means, the moving direction, moving speed and position of stage moving portion 8 with respect to stage base 7 can be varied. A substrate stage 11 is fixed to stage moving portion 8 with a base portion 10 interposed. A substrate 12 is fixed on that surface of substrate stage 11 which is opposed to target stage 13.

Laser light source 18 oscillates laser light 16 incident on target material 14. The laser light 16 oscillated in laser light source 18 has its optical axis changed to a prescribed direction at optical system 19 and is directed into chamber 2 through an incident window 17 provided at chamber 2. Within chamber 2, the surface of target material 14 is irradiated with laser light 16, so that atoms and the like constituting target material 14 are scattered from the surface of target material 14. Then, above target material 14, a plume 15 is formed of the atoms and the like scattered from target material 14. Plume 15 comes partially into contact with the surface of substrate 12, causing the atoms and the like to be deposited on the surface of substrate 12 as the deposition material. As a result, a prescribed film can be formed on the surface of substrate 12.

The angle which the surface of substrate 12 forms with the surface of target material 14 can be varied arbitrarily by moving substrate stage 11 as the substrate holding member and XY stage 9 along arc-shaped guide 4 as the guide member. As can be seen from Fig. 1, XY stage 9 is moved in the direction of arrow 33 along arch-shaped 4, whereby substrate 12 can be inclined in the same direction as the inclination direction of the optical axis of laser light 16 with respect to target material 14.

In this way, film deposition apparatus 1 can be used to carry out the film deposition step with the angle of the surface of substrate 12 with respect to the surface of target material 14 (the inclination angle) being set at an arbitrary angle. The deposition conditions such as a deposition rate on substrate 12 can be varied by varying the inclination angle. Therefore, the deposition conditions can be varied arbitrarily to be adapted to the property of the formed film by changing the inclination angle.

Furthermore, support member 3 allows arc-shaped guide 4 to be fixed at any position upward and downward. As a result, the distance between substrate 12 and target material 14 can readily be changed by changing the position of arc-shaped guide 4 upward and downward. The distance between substrate 12 and target material 14 can also be varied easily by moving target stage 13 upward and downward.

Fig. 2 shows the configuration of film deposition apparatus 1 based on the function of each of equipment constituting film deposition apparatus 1. Film deposition apparatus 1 includes a laser light source 18, a substrate holding portion 22, a substrate angle varying portion 21, a substrate swinging portion 23, a substrate-target material distance varying portion 22, and a control portion 24. Laser light source 18 in Fig. 2 corresponds to laser light source 18 shown in Fig. 1. Substrate holding portion 20 corresponds to substrate stage 11 as the substrate holding member shown in Fig. 1. Substrate angle varying portion 21 as the varying means corresponds to arc-shaped guide 4, support member 5, and guide connection portion 6 shown in Fig. 1. Substrate swinging portion 23 as the moving means corresponds to XY stage 9 shown in Fig. 1. Substrate-target material distance varying portion 22 corresponds to target stage 13 and support member 3. These laser light source 18, substrate holding portion 20, substrate angle varying portion 21, substrate swinging portion 23, and substrate-target material distance varying portion 22 are controlled by a controller 2 as control portion 24, though not shown in Fig. 1. It is noted that film deposition apparatus 1 is provided with a gas supply portion, though not shown, which regulates a supply amount and a pressure of an atmosphere gas within chamber 2.

A film deposition method using film deposition apparatus 1 shown in Figs. 1 and 2 will now be described.

In film deposition apparatus 1 shown in Figs.1 and 2, as described above, the angle between target material 14 and substrate 12 can be varied arbitrarily, and in addition, the relative position of substrate 12 with respect to target material 14 can readily be changed using XY stage 9.

In this way, in forming a film on substrate 12, a film can be formed on the surface of substrate 12 with the relative position of substrate 12 with respect to target material 14 being moved by operating XY stage 9. Therefore, it is possible to deposit the atoms and the like over the entire substrate 12 uniformly as the deposition material scattered from target material 14. As a result, a uniform film can be formed over the entire surface of substrate 12.

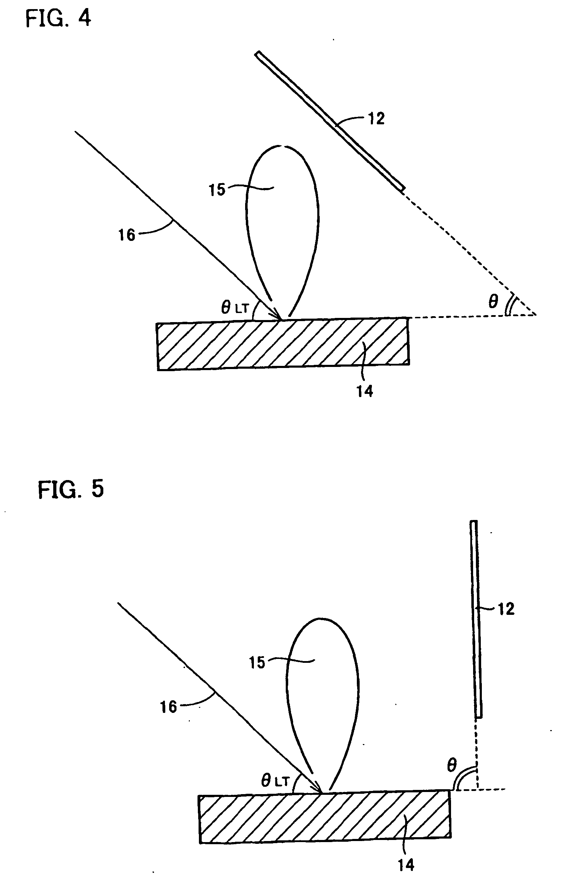

The moving direction of stage moving portion 8 in XY stage 9 is approximately parallel to the surface of substrate 12. Therefore, the position of substrate 12 with respect to target material 14 can be moved with an angle θ (see Fig. 4) of the surface of substrate 12 to the surface of target material 14 being always kept constant. Therefore, it is possible to keep the deposition conditions constant over the entire deposition surface of substrate 12. As a result, a uniform film can readily be formed over the entire deposition surface of substrate 12.

When an oxide superconductor film or the like is formed on substrate 12 using film deposition apparatus 1 shown in Figs. 1 and 2 as described above, laser ablation can be performed with the varied angles between target material 14 and substrate 12, which will be described below.

For example, as shown in Fig. 1, plume 15 is formed by irradiating target material 14 with laser light 16 in a state where target material 14 and substrate 12 are arranged to be approximately parallel to each other. The atoms and the like from target material 14 as the deposition material are deposited from plume 15 onto the deposition surface of substrate 12 (that surface of substrate 12 which is opposed to target material 14), thereby forming a prescribed film on the deposition surface of substrate 12. The positional relation between substrate 12 and target material 14 here is schematically shown in Fig. 3. Fig. 3 is a schematic view illustrating a first exemplary deposition method using the film deposition apparatus shown in Figs. 1 and 2.

Referring to Fig. 3, target material 14 is irradiated with laser light 16 in a state where target material 14 and substrate 12 are arranged approximately parallel to each other. It is assumed that the incident angle of laser light 16 on the surface of target material 14 is represented as an angle θ_{LT}. Where the surface of target material 14 and the surface of substrate 12 are arranged approximately parallel to each other, substrate 12 may possibly block the optical axis of laser light 16 when substrate 12 is moved in the two-dimensional direction (the direction parallel to the surface of stage base 7) using XY stage 9. The size of substrate 12 is therefore restricted to such a size that does not cause the interference with the optical axis of laser light 16. Accordingly, though the arrangement as shown in Fig. 3 can be realized in the film deposition apparatus shown in Fig. 1, the arrangement shown in Fig. 3 imposes limitations on the increase in the area of substrate 12.

The arrangement shown in Fig. 3, however, increases a deposition rate of the film formed on substrate 12, as compared with the substrate arrangement shown in Figs. 4 and 5 as described later. Therefore, when a priority is given to a deposition rate, the first exemplary deposition method shown in Fig. 3 can be applied.

Now consider a film deposition step is performed with the surface of substrate 12 being inclined to the surface of target material by angle θ, as shown in Fig. 4.

The arrangement shown in Fig. 4 can be realized by moving guide connection portion 6 in the direction of arrow 33 on arc-shaped guide 4 and thereby tilting XY stage 9, base portion 10, and substrate stage 11 to target material 14. In Fig. 4, laser light 16 and the surface of substrate 12 are then approximately parallel to each other (in other words, incident angle θ_{LT} of laser light 16 to target material 14 is approximately equal to angle θ of the surface of substrate 12 to target material 14).

In the arrangement of the substrate 12 and target material 14 as shown in Fig. 4, substrate 12 no longer blocks the path of laser light 16 as energy rays. Therefore, substrate 12 can be moved limitlessly in any direction in the two-dimensional plane along the surface of substrate 12 by operating XY stage 9 (in other words, substrate 12 does not interfere with the optical axis of laser light 16, with any movement of substrate 12, with any size of substrate 12). As a result, substrate 12 can readily be increased in area.

In forming a film on substrate 12, XY stage 9 is operated to move the relative position of substrate 12 with respect to target material 14, thereby resulting in a uniform film over the entire surface of substrate 12.

In the film deposition method shown in Fig. 4, though the deposition rate is slightly lower than that in the deposition method shown in Fig. 3, the number of particles in the formed film is reduced, resulting in a film having a relatively smooth surface. Therefore, the present deposition method can be applied, for example, where it is desired to deposit a film having a good film property while maintaining an appropriate deposition rate.

Furthermore, in film deposition apparatus 1 shown in Figs.1 and 2, substrate 12 can be arranged approximately perpendicular to target material 14 by performing the step of moving XY stage 9 along arc-shaped guide 4 as the angle varying step, as shown in Fig. 5. In the film deposition method shown in Fig. 5, the angle θ of the surface of substrate 12 to the surface of target material is approximately 90°.

In this case, with the arrangement where target material 14 does not extend below substrate 12, substrate 12 can be moved limitlessly in any direction in the two-dimensional plane approximately parallel to the surface of substrate 12 by operating XY stage 9. As a result, as similar to the deposition method shown in Fig. 4, substrate 12 can readily be increased in area.

In addition, at the angle θ of 90° in this manner, though the deposition rate is lower than that in the deposition method shown in Figs. 3 and 4, the particle density is significantly reduced in the film surface. Therefore, when the highest priority is given to the film property, it is preferable to apply the film deposition method shown in Fig. 5.

It is noticed that in the film deposition method in the present invention, the angle θ can be set at any value in the range exceeding 0° and not more than 90°.

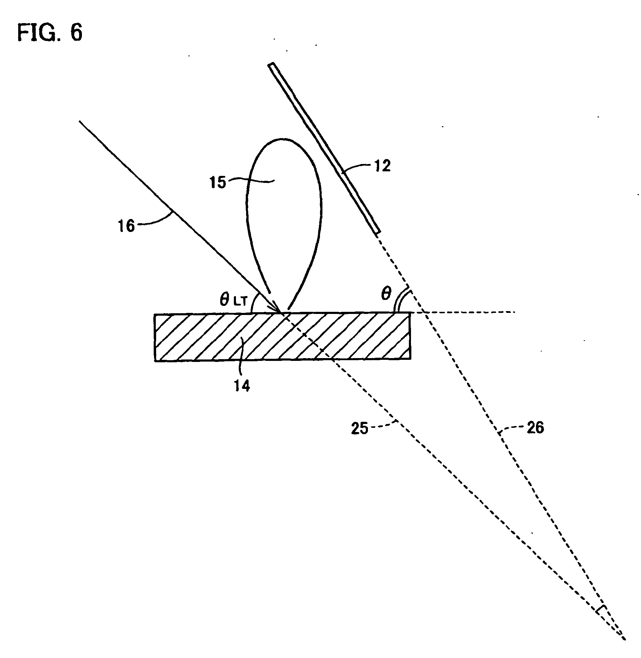

In the film deposition method using film deposition apparatus 1 shown in Figs. 1 and 2, as shown in Fig. 6, the deposition step can be carried out in the arrangement of substrate 12 where the angle θ between the surface of target material 14 and the surface of substrate 12 is larger than the angle θ_{LT} between the surface of target material 14 and the optical axis (path) of laser light 16 (in other words, the arrangement of substrate 12 where the optical axis 25 of laser light 16 intersects extended line 26 in the direction in which the surface of substrate 12 extends). The step of moving XY stage 9 along arc-shaped guide 4 is carried out as the angle varying step to vary the angle θ. If the angle θ_{LT} is 45°, for example, the angle θ is set at a value in the range exceeding 45° and not more than 90°. In this case, laser light 16 is not blocked by substrate 12 as well even when substrate 12 is moved in the direction along the surface thereof. Therefore, the effect similar to that in the deposition method shown in Figs. 4 and 5 can result.

Furthermore, the deposition conditions such as the deposition rate on the substrate 12 surface can arbitrarily changed by varying the angle θ. Therefore, the film property such as the particle density in the film can arbitrarily be varied by varying the angle θ. Therefore, it becomes possible to select the deposition conditions in accordance with the property of the formed film.

In the deposition step, the moving direction in which the relative position of the substrate with respect to the target material is moved is approximately parallel to the surface of the substrate.

XY stage 9 can be operated to move the position of substrate 12 with respect to target material 14 with the angle θ of the surface of substrate 12 to the surface of target material 14 being always kept constant, as described above. Therefore, any of the film deposition methods shown in Figs. 3-6 can readily result in a film uniform over the entire substrate 12.

Description will now be made to the moving direction in which substrate 12 is moved in the plane parallel to the surface of substrate 12, in the film deposition method using film deposition apparatus 1 shown in Figs.1 and 2. As described above, film deposition apparatus 1 is provided with XY stage 9, and substrate stage 11 is connected to stage moving portion 8 of XY stage 9. XY stage 9 is operated to allow the relative position between target material 14 and substrate 12 to be varied arbitrarily in the direction along the surface of substrate 12. On the other hand, the position of plume 15 hardly changes with respect to target material 14, as laser light 16 is applied to a particular point of target material 14. Therefore, the position of substrate 12 with respect to plume 15 can be varied by operating XY stage 9. As a result, it is possible to vary arbitrarily the position of the region in which a film is formed on the surface of substrate 12 by deposition of the atoms as the deposition material from plume 15.

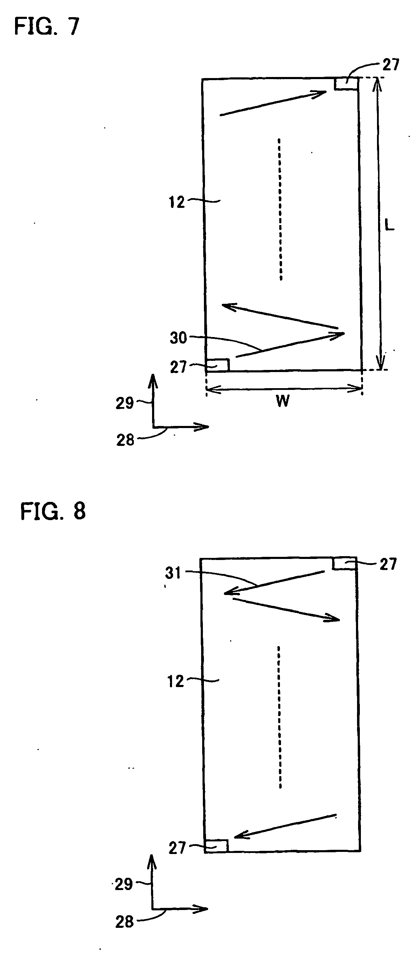

Referring to Figs. 7 and 8, a method according to the invention of moving substrate 12 using XY stage 9 will be described. Figs. 7 and 8 show the deposition surface in substrate 12 (that surface which is opposed to target material 14).

Referring to Figs. 7 and 8, in the film deposition method using the film deposition apparatus shown in Fig. 1, a relatively large substrate 12 is used and therefore deposition region 27 in the surface of substrate 12 is a part of the entire surface of substrate 12. Here, this deposition region 27 is gradually moved in the direction of arrow 30 as shown in Fig. 7, so that a prescribed film is formed continuously on the surface of substrate 12. Deposition region 27 moves from one end portion to the other end portion in the width W direction of substrate 12 as shown in Fig. 7, and at the same time, it gradually moves from one end portion toward the other end portion in the length L direction in the direction indicated by arrow 29.

It is noted that the move of deposition region 27 in the surface of substrate 12 as shown in Fig. 7 can be realized in film deposition apparatus 1 shown in Fig. 1 in the following manner. In film deposition apparatus 1, plume 15 is formed by irradiating a prescribed region of target material 14 with laser light 16 with the position of target material 14 being kept constant. The position of plume 15 hardly moves, as the position of target material 14 and the optical axis of laser light 16 are fixed. In this state, XY stage 9 is operated to gradually move substrate 12 in the direction opposite to the direction of arrow 30. As a result, as shown in Fig. 7, deposition region 27 can be moved in the surface of substrate 12. It is noted that the speed at which substrate 12 is moved is determined in consideration of the deposition rate in deposition region 27, the size of deposition region 27, the size of substrate 12 (the width W and the length L), and the like. The moving speed and the moving direction of substrate 12 is determined so as not to cause a region where film is not formed in the surface of substrate 12 (in other words, the speed in the direction indicated by arrow 29 and the speed in the direction indicated by arrow 28 are balanced for the moving speed of substrate 12, so as not to cause a region that is not scanned by deposition region 27).

As shown in Fig. 7, after deposition region 27 reaches from the one end portion to the other end portion of substrate 12, substrate 12 is again moved in the direction opposite to that in the step shown in Fig. 7, as shown in Fig. 8. As a result, the deposition region can be moved from the other end portion to the one end portion in the length L direction in substrate 12. In this way, a film of a prescribed thickness can be formed by moving deposition region 27 in the surface of substrate 12.

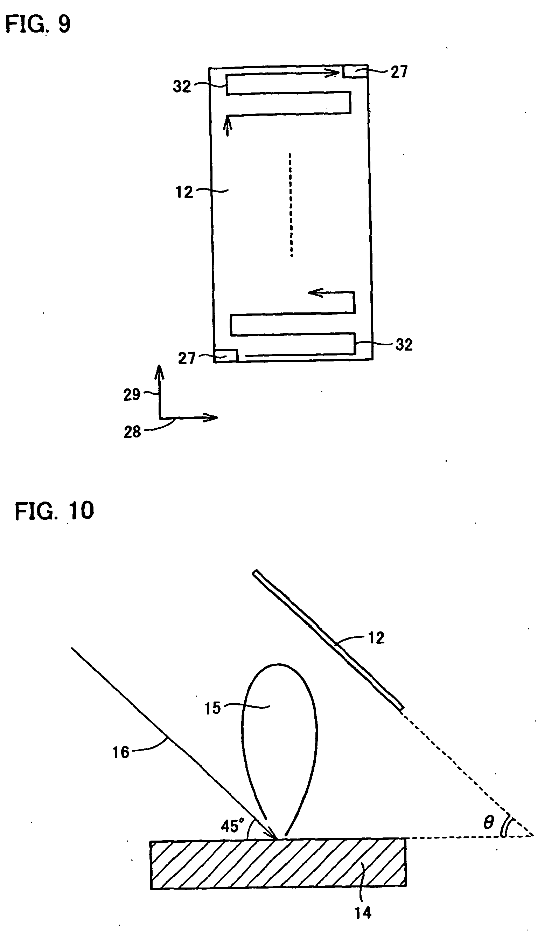

As a method according to the invention of moving substrate 12, substrate 12 may be moved as shown in Fig. 9, in place of the method shown in Figs. 7 and 8. Referring to Fig. 9, (a) deposition region 27 is moved in the direction indicated by arrow 28, so that deposition region 27 is moved from the one end portion to the other end portion in the width direction of substrate 12. (b) Thereafter, deposition region 27 is moved in the direction approximately parallel to arrow 29. (c) Deposition region 27 is further moved in the direction opposite to the direction indicated by arrow 28, so that deposition region 27 is moved from the other end portion to the one end portion in the width direction of substrate 12. (d) Deposition region 27 is then moved in the direction approximately parallel to arrow 29. The steps (a)-(d) above are repeated. Here, in the above steps (b) and (d), deposition region 27 is moved in the direction approximately parallel to arrow 29 by a distance approximately equal in length to the width of deposition region 27 in the direction of arrow 29. As a result, a film can be formed densely and uniformly on the surface of substrate 12.

The film deposition method using the film deposition apparatus shown in Figs. 1 and 2 can be applied to a deposition step for an oxide superconductor such as an RE 123-based oxide superconductor or a bismuth-based oxide superconductor. In this case, it is possible to readily form a uniform oxide superconductor film on a large-area substrate.

In addition, the film deposition method using the film deposition apparatus in the present invention may be applied to a deposition step for an intermediate film arranged between a substrate and an oxide superconductor. The intermediate film formed by the deposition method in the present invention includes, for example, yttria-stabilized zirconia, cerium oxide, magnesium oxide, strontium titanate, or the like. In this way, by applying the film deposition apparatus and method in the present invention to the deposition step for the intermediate film, a uniform intermediate film can readily be formed on a large-area substrate.

As substrate 12 on which an oxide superconductor film or an intermediate film is formed as described above, sapphire, lanthanum aluminate, strontium titanate, or LSAT (Lanthanum Strontium Aluminum Titanium Oxide), or the like can be used.

The film deposition apparatus shown in Figs. 1 and 2 was used to prepare samples for measurement of film thicknesses, the number of particles, and the like, as described below.

### (Example 1)

Using the film deposition apparatus shown in Fig. 1, HoBa₂Cu₃Ox superconductor film (referred to as HoBCO superconductor film hereinafter) was formed on a lanthanum aluminate substrate as a substrate using laser ablation. The lanthanum aluminate substrate used here is shaped like a rectangular having a width W of 3 cm and a length L of 10 cm. HoBCO sintered body of 20 centimeters square was used as a target material.

The prepared samples include three kinds: a sample as a comparative example, and Samples 1 and 2 as examples. In the deposition step of these samples, the following arrangement of the target material and the substrate was employed. The deposition step for the sample as the comparative example employed the arrangement in which target material 14 and substrate 12 are approximately parallel to each other as shown in Fig. 3. The deposition step of Sample 1 as the example of the present invention employed the arrangement shown in Fig. 4 (specifically, the arrangement in which the direction of the optical axis of laser light 16 is approximately parallel to the direction of the surface of substrate 12). The deposition step of Sample 2 as an example employed the arrangement shown in Fig. 5 where target material 14 is perpendicular to substrate 12.

In performing a deposition, XY stage 9 was operated to move deposition region 27 on substrate 12 using the method as shown in Figs. 7 and 8. The moving speed of substrate 12 was such that the speed in the direction parallel to arrow 29 shown in Fig. 7 and the speed in the direction parallel to arrow 28 were both 5 mm/sec. Substrate 12 was repeatedly scanned with deposition region 27, as shown in Figs. 7 and 8, thereby attaining a uniform thickness of HoBCO superconductor film formed on the surface of substrate 12.

It is noted that the same deposition conditions were basically used for these three kinds of sample, except the arrangement of the substrate. As the deposition conditions as used, the temperature of substrate 12 in the deposition was 750°C. An oxygen gas atmosphere were introduced in chamber 2. The pressure within chamber 2 was set at 13.3Pa (100mTorr). The repetition frequency of laser light 16 was set at 20 Hz and the power of the laser light was set at 700 mJ. In all of the sample as the comparative example and Samples 1 and 2 as the examples, the incident angle θ_{LT} of laser light 16 with respect to the surface of target material 14 (see Figs. 3-5) was set at 45°. The deposition time was 30 minutes for all of the samples.

For each of the sample as the comparative example and Samples 1 and 2 as the examples, which were manufactured in this manner, a thickness of the formed oxide superconductor thin film, the number of particles in the formed film, and a critical current density were measured. The results are shown in Table 1.

**Table 1**

| | | Film thickness (µ m) | Number of particles (Number /100 µ m²) | Jc (MA/cm²) | Others |
|---|---|---|---|---|---|
| Comparative Example | | 6.25 | 107 | 3.12 | Substrate-target parallel |
| Example | Sample 1 | 4.01 | 53 | 3.15 | Substrate-laser light: parallel |
| | Sample 2 | 1.13 | 3 | 3.08 | Substrate-target: perpendicular |

As can be seen from Table 1, the thickest film was obtained in the sample of the comparative example where substrate 12 and target material 14 are arranged parallel to each other. In other words, based on that the deposition time is consistently 30 minutes in any of the samples, the highest deposition rate was attained when substrate 12 and target material 14 are parallel to each other as in the comparative example, and the deposition rate is reduced with increasing inclination angle of the substrate with respect to the target material as Samples 1 and 2 of the examples.

Furthermore, the number of particles in the formed film is greatest in the comparative example, and it is reduced in Samples 1 and 2 of the examples, accordingly. Therefore, it can be seen that it is effective to arrange the surface of substrate 12 approximately perpendicular to the surface of target material 14 as in Sample 2 of the example, in order to smooth significantly the surface of the formed film.

As in Sample 1 of the example where the substrate 12 and laser light 16 extend in the direction approximately parallel to each other, substrate 12 does not interfere with the optical axis of laser light 16 even if substrate 12 is arbitrarily moved in the direction parallel to the surface thereof. In other words, in principle, the arrangement as in Sample 1 of the example allows substrate 12 to be increased in size without the constraints of the position of the optical axis of laser light.

It is noted that all the comparative example, Samples 1 and 2 of the example have approximately equal critical current density Jc and exhibit a good property.

In this way, using the film deposition apparatus shown in Fig. 1, it is possible to form a film on a substrate under various deposition conditions from those as in the comparative example where the deposition rate has a highest priority to those as in Sample 2 of the example where an significantly smooth surface of the deposited film is attained.

### (Example 2)

An experimental deposition of HoBCO superconductor film was performed under the deposition conditions basically similar to the deposition conditions in Samples 1 and 2 in Example 1. In this experimental deposition, the deposition was performed under the condition with the varied angle θ between substrate 12 and target material 13. Specifically, referring to Fig. 10, Sample 3 was prepared by performing a deposition with the angle θ of 60° between the surface of target material 14 and the surface of substrate 12, and Sample 4 was prepared by performing a deposition with the angle θ of 75°, while the angle of the optical axis of laser light 16 with respect to the surface of target material 14 was fixed at 45°. In any deposition step for forming Samples 1-4, substrate 12 can be moved arbitrarily in the direction parallel to the surface thereof without blocking laser light 16. In other words, substrate 12 does not interfere with laser light 16. As a result, an oxide superconductor thin film can be formed reliably on substrate 12 even when substrate 12 has a larger size.

For the resulting Samples 3 and 4, in a manner similar to Example 1, a film thickness, the number of particles, and a critical current density were measured. The results are shown in Table 2 with data of Samples 1 and 2.

**Table 2**

| ID | Angle between substrate and target : θ (° ) | Film thickness (µm) | Number of particles (Number/100 µ m²) | Jc (MA/cm²) |
|---|---|---|---|---|
| Sample 1 | 45 | 4.01 | 53 | 3.15 |
| Sample 3 | 60 | 3.16 | 37 | 3.14 |
| Sample 4 | 75 | 2.51 | 21 | 3.13 |
| Sample 2 | 90 | 1.13 | 3 | 3.08 |

As shown in Table 2, the thickness of the formed superconductor film is reduced with increasing angle θ between the substrate and the target (in other words, the deposition rate is lowered). On the other hand, the number of particles in the superconductor film is reduced. In any of the samples, critical current density Jc exhibits a sufficient value.

### (Example 3)

In the arrangement of target material 14, substrate 12 and laser light 16 as shown in Fig. 10, a sample as an example was prepared where HoBCO superconductor film was formed on substrate 12 using a rectangular-shaped lanthanum aluminate substrate having a width W of 5 cm and a length L of 20 cm as a substrate 12, with the angle θ of 45° between target material 14 and substrate 12. In the deposition of the sample of the example, as described with reference to Figs. 7 and 8, substrate 12 was moved in the plane parallel to the surface of substrate 12. The moving speed of substrate 12 was such that both of the speed in the direction parallel to arrow 29 and the speed in the direction parallel to arrow 28 in Fig. 7 were 5 mm/sec. The other deposition conditions were basically similar to the deposition conditions for Sample 1 in Example 1.

A sample was prepared as a comparative example where a deposition was performed using the following deposition conditions. The deposition conditions for the sample as the comparative example were similar to those in the aforementioned example in regard of the substrate temperature in deposition, the atmosphere gas and pressure, as well as the repetition frequency of laser and the laser power. On the other hand, as to the laser light applied on target material 14, a beam homogenizer of an optical system was used to expand irradiation region of laser light applied on the target material in order to form a deposition region larger than the width W in the shorter axial direction (the width W direction) of substrate 12. The energy variation of the beam homogenizer is ± 5%, and a line beam having a width of 7 cm can be obtained. In this manner, the size of plume 15 can be increased by irradiating the target material with the line beam with a width of 7 cm. As described above, the substrate is sized to have a width W of 5 cm and a length L of 20 cm. Therefore, the width of the deposition region on the substrate can be increased equivalently to the width W of the substrate. Accordingly, using the aforementioned beam homogenizer, a deposition region having a width equivalent to the width W of the substrate (5 cm) was formed on substrate 12 in the comparative example. Substrate 12 was transferred only in the length L direction (only in a single-dimensional direction) with the arrangement of the deposition region extending from the one end portion to the other end portion in the width W direction of the substrate. In this way, in the sample as the comparative example, an oxide superconductor film was formed over the entire substrate.

For each of the resulting samples in the example and the comparative example, a film thickness distribution of the oxide superconductor film was measured. The results are shown in Table 3.

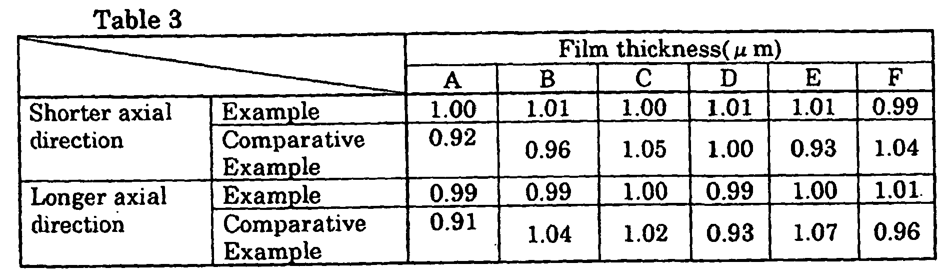

In Table 3, the shorter axial direction refers to the width W direction shown in Figs. 7 and 8, and the longer axial direction refers to the length L direction shown in Figs 7 and 8. The thicknesses of the oxide superconductor film were measured at six points A-F arranged at regular intervals in each of these directions. As a result, as can be seen from Table 3, the sample of the example has a film thickness variation smaller than the comparative example.

For the same samples, critical current density Jc was measured at each of the points A-F shown in Table 3. The results are shown in Table 4.

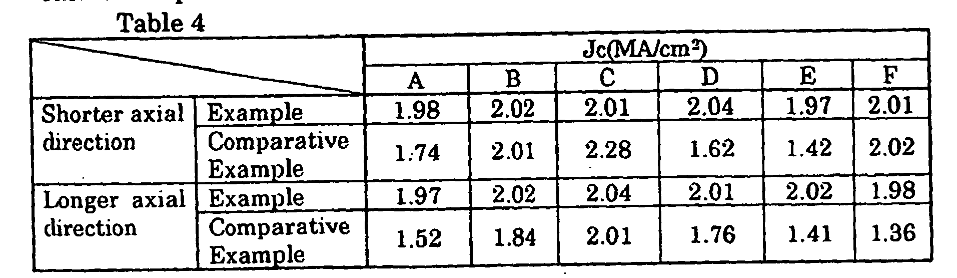

As can be seen from Table 4, both in the shorter axial direction and longer axial direction, the example of the present invention has a critical current density Jc variation smaller than the comparative example.

### (Example 4)

Using a rectangular-shaped sapphire substrate having a width W of 5 cm and a length L of 20 cm as substrate 12, samples as the example and the comparative example were prepared where a cerium oxide intermediate layer was deposited on the sapphire substrate using laser ablation.

The deposition step for the cerium oxide intermediate layer in the sample of the example employed the arrangement of target material 14, substrate 12 and laser light 16 which was similar to the arrangement in the deposition step for the sample as the example in Example 3. As the deposition conditions, the substrate temperature in deposition was 600°C, the atmosphere was argon gas, the pressure of the atmosphere was 13.3 Pa (100mTorr), the repetition frequency of laser was 150 Hz, and the laser power was 600 mJ. In the deposition, substrate 12 was moved as shown in Figs. 7 and 8 in the manner similar to the sample as the example in Example 3. The conditions such as the moving speed at which substrate 12 is moved is similar to the conditions such as the moving speed of the substrate in the sample of the example in Example 3.

In the deposition step for the cerium oxide intermediate layer in the sample of the comparative example, a beam homogenizer was used in a manner similar to the comparative example in Example 3. The other deposition conditions were similar to the deposition conditions in the example in Example 4 described above.

For the resulting samples as the example and the comparative example, film thickness distributions were measured. The results are shown in Table 5.

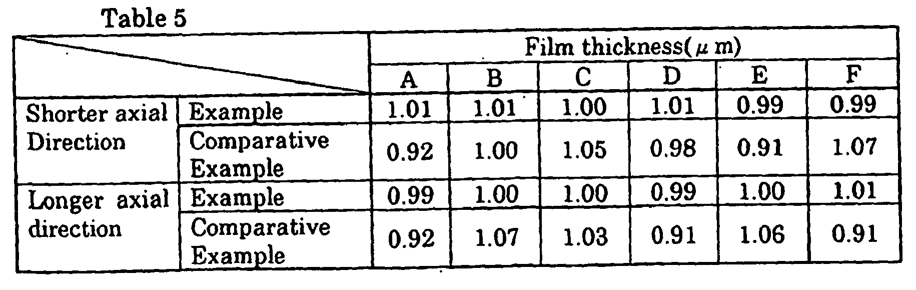

Referring to Table 5, the measurement was performed at six points of A-F arranged at regular intervals in both of the shorter axial direction and the longer axial direction, similarly to Example 3. As can be seen from Table 5, the example has a film thickness variation in the cerium oxide intermediate layer smaller than the comparative example.

### (Example 5)

The sample of the example in Example 5 was prepared by forming HoBCO superconductor film on the cerium oxide intermediate layer in the sample of the example in Example 4, under the deposition conditions similar to those in the sample of the example in Example 3.

In addition, HoBCO superconductor film was formed on the cerium oxide intermediate layer in the sample of the comparative example in Example 4, under the deposition conditions similar to those in the comparative example in Example 3 (that is, the conditions using a beam homogenizer).

For each of the resulting samples in the example and the comparative example, a film thickness and critical current density Jc were measured. The results are shown in Tables 6 and 7.

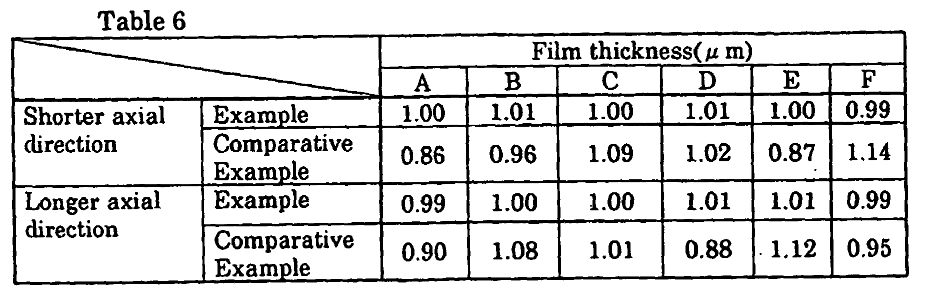

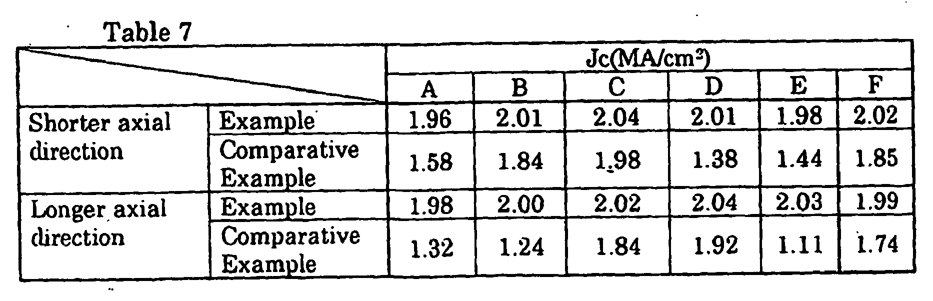

As shown in Tables 6 and 7, for each of the comparative example and the example, the film thickness and critical current density Jc were measured at the measurement points A-F arranged at regular intervals in each of the shorter axial direction and the longer axial direction, similarly to Examples 3 and 4. As can be seen from Tables 6 and 7, the example has a film thickness variation smaller than the comparative example and also has a smaller critical current density Jc variation.

The embodiments and examples disclosed here should be taken by way of illustration not by way of limitation. The scope of the present invention is shown not in the embodiments and examples described above but in the claims

### Industrial Applicability

As described above, the film deposition method and apparatus in accordance with the present invention can be used as a method and apparatus for forming a film on a surface of a large-area substrate. In particular, it is useful when an oxide superconductor thin film is formed on a surface of a large-area substrate.

## Claims

1. A film deposition method of forming a film by scattering a deposition material from a surface of a target material (14) and depositing the scattered deposition material onto a surface of a substrate (12), comprising:
- a step of arranging said substrate (12) and said target material (14) such that the surface of said substrate (12) forms an angle to the surface of the target material (14); and
- a deposition step of forming said film on said substrate (12) in such a manner that an area of a surface of said film is continuously increased in a two-dimensional direction, while moving a relative position of said substrate (12) with respect to said target material (14);
**characterized in that** in said deposition step,
- a moving direction in which a relative position of said substrate (12) with respect to said target material (14) is moved, is approximately parallel to the surface of said substrate (12); and
- deposition region (27) in which the substrate surface is provided with a film, is a portion of the entire surface of substrate (12) and said region (27) moves from one end to the other end in the direction of width W of said substrate (12) and simultaneously from one end to the other end in the direction of length L of said substrate (12) gradually.

2. A film deposition method of forming a film by scattering a deposition material from a surface of a target material (14) and depositing the scattered deposition material onto a surface of a substrate (12), comprising:
- a step of arranging said substrate (12) and said target material (14) such that the surface of said substrate (12) forms an angle to the surface of the target material (14); and
- a deposition step of forming said film on said substrate (12) in such a manner that an area of a surface of said film is continuously increased in a two-dimensional direction, while moving a relative position of said substrate (12) with respect to said target material (14);
**characterized in that** in said deposition step,
- a moving direction in which a relative position of said substrate (12) with respect to said target material (14) is moved, is approximately parallel to the surface of said substrate (12);
- deposition region (27) in which the substrate surface is provided with a film, is a portion of the entire surface of substrate (12) and said region (27):
(a) moves from one end to the other end in the direction of width W of said substrate (12);
(b) then moves in the direction of length L of said substrate (12);
(c) furthermore moves from said other end to said one end in the direction of the width W of said substrate (12);
(d) then moves in the direction of length L of said substrate (12); and
(e) repeats steps (a) to (d).

3. The film deposition method according to claim 1 or 2, wherein an angle (θ) between the surface of said substrate (12) and the surface of said target material (14) exceeds 0° and is equal to or less than 90°.

4. The film deposition method according to claim 1 or 2, wherein energy rays (16) are applied to the surface of said target material (14) in order to scatter the deposition material from the surface of said target material (14).

5. The film deposition method according to claim 4, wherein an angle (θ_{LT}) between a path (25) of said energy rays (16) and the surface of said target material (14) is smaller than an angle (θ) between the surface of said substrate (12) and the surface of said target material (14).

6. The film deposition method according to claim 4, wherein a path (25) of said energy rays (16) is approximately parallel to the surface of said substrate (12).

7. The film deposition method according to claim 1 or 2, further comprising an angle varying step of changing an angle (θ) between the surface of said substrate (12) and the surface of said target material (14) by varying a relative position of said substrate (12) with respect to said target material (14).

8. The film deposition method according to claim 1 or 2, wherein said film includes an oxide superconductor.

9. The film deposition method according to claim 8, wherein said oxide superconductor includes one kind selected from the group consisting of an RE123- based oxide superconductor and a bismuth-based oxide superconductor.

10. The film deposition method according to claim 1 or 2, further comprising a step of forming an oxide superconductor on said film, wherein said film is an intermediate film positioned between said substrate (12) and said oxide superconductor.

11. The film deposition method according to claim 10, wherein said film includes at least one kind selected from the group consisting of yttria-stabilized zirconia, cerium oxide, magnesium oxide, and strontium titanate.

12. The film deposition method according to claim 1 or 2, wherein a material forming said substrate (12) includes at least one selected from the group consisting of sapphire, lanthanum aluminate, strontium titanate, and Lanthanum Strontium Aluminum Titanium oxide (LSAT).

13. A film deposition apparatus (1) to form a thin film by scattering a deposition material from a surface of a target material (14) and depositing the scattered deposition material onto a surface of a substrate (12) comprising:
- varying means (4-6; 21) for varying an angle of the surface of said substrate (12) to the surface of said target material (14);
- moving means (9; 23) for moving a relative position of said substrate (12) with respect to said target material (14) in the direction approximately parallel to the surface of said substrate (12);
**characterized in that**,
- said moving means (9; 23) is capable of moving the substrate's position relative to the target material (14) in the directions of the width (W) and length (L) of said substrate (12).

14. The film deposition apparatus according to claim 13, wherein said varying means (4-6, 9-11, 21) includes
- an arc-shaped guide member (4) and
a substrate holding member (11) movably mounted to said guide member (4) for holding said substrate (12).

15. The film deposition apparatus (1) according to claim 13 further comprising irradiation means (18) for irradiating the surface of said target material (14) with energy rays (16) in order to scatter said deposition material from the surface of said target material (14).

## Patentansprüche

1. Filmaufbringungsverfahren zur Ausbildung eines Films durch Streuen eines Abscheidungsmaterials von einer Oberfläche eines Zielmaterlals (14) und Aufbringen des gestreuten Abscheidungsmaterials auf eine Oberfläche eines Substrats (12), umfassend:
- einen Schritt des Anordnens des Substrats (12) und des Zielmaterials (14) derart, daß dle Oberfläche des Substrats (12) einen Winkel zu der Oberfläche des Zielmaterials (14) bildet; und
- einen Aufbrlngungsschritt zur Ausbildung des Films auf dem Substrat (12) in einer solchen Weise, daß ein Bereich einer Oberfläche des Films kontinulerllch in zweldlmenslonaler Richtung vergrößert wird, während dabei eine relative Position des Substrats (12) In Bezug auf das Zielmatarial (14) bewegt wird;
**dadurch gekennzeichnet, daß** in dem Aufbringungsschritt
- eine Bewegungsrichtung, in welcher eine relative Position des Substrats (12) in Bezug auf das Zielmaterial (14) bewegt wird, annähernd parallel zu der Oberfläche des Substrats (12) ist, und
- der Aufbringungsbereich (27), in welchem die Oberfläche des Substrats mit einem Film versehen wird, ein Abschnitt der gesamten Oberfläche des Substrats (12) ist und sich der Bereich (27) von dem einen Ende zu dem anderen Ende in der Richtung der Breite W des Substrats (12) und gleichzeitig graduell von dem einen Ende zu dem anderen Ende in der Richtung der Länge L des Substrats (12).

2. Filmaufbringungsverfahren zur Ausbildung eines Films durch Streuen eines Abscheidungsmaterials von einer Oberfläche eines Zielmaterials (14) und Aufbringen des gestreuten Abscheidungsmaterials auf eine Oberfläche eines Substrats (12), umfassend:
- einen Schritt des Anordnens des Substrats (12) und des Zielmaterials (14) derart, daß die Oberfläche des Substrats (12) einen Winkel zu der Oberfläche des Zielmaterials (14) bildet, und
- einen Aufbringungsschritt zur Ausbildung des Films auf dem Substrat (12) In einer solchen Weise, daß ein Bereich einer Oberfläche des Films kontinulerlich in zweidimensionaler Richtung vergrößert wird, während dabei eine relative Position des Substrats (12) in Bezug auf das Zielmaterial (14) bewegt wird;
**dadurch gekennzeichnet, daß** in dem Aufbringungsschritt
- eine Bewegungsrichtung, in welcher eine relative Position des Substrats (12) In Bezug auf das Zielmaterial (14) bewegt wird, annähernd parallel zu der Oberfläche des Substrats (12) ist,
- der Aufbringungsbereich (27), in welchem die Oberfläche des Substrats mit einem Film versehen wird, ein Abschnitt der gesamten Oberfläche des Substrats (12) ist, und der Bereich (27):
a) sich von dem einen Ende zu dem anderen Ende in der Richtung der Breite W das Substrats (12) bewegt;
b) sich dann in der Richtung der Länge L des Substrats (12) bewegt;
c) sich ferner von dem anderen Ende zu dem einen Ende in der Richtung der Breite W des Substrats (12) bewegt;
d) sich dann In der Richtung der Länge L des Substrats (12) bewegt; und
e) die Schritte (a) bis (d) wiederholt.

3. Filmaufbringungsverfahren nach Anspruch 1 oder 2, wobei ein Winkel (θ) zwischen der Oberfläche des Substrats (12) und der Oberfläche des Zielmaterials (14) größer als 0° ist und gleich oder kleiner als 90° ist.

4. Filmaufbringungsverfahren nach Anspruch 1 oder 2, wobei Energiestrahlen (16) auf die Oberfläche des Zielmaterials (14) angewandt werden, um das Abscheidungsmaterial von der Oberfläche des Zielmaterials (14) zu streuen.

5. Filmaufbringungsverfahren nach Anspruch 4, wobel eln Winkel (θ_{LT}) zwischen einem Laufweg (25) der Energiestrahlen (18) und der Oberfläche des Zielmaterials (14) kleiner als ein Winkel (θ) zwischen der Oberfläche des Substrats (12) und der Oberfläche des Zielmaterials (14) ist.

6. Filmaufbringungsverfahren nach Anspruch 4, wobei ein Laufweg (25) der Energlestrahlen (16) annähernd parallel zu der Oberfläche des Substrats (12) ist.

7. Fllmaufbrlngungsverfahren nach Anspruch 1 oder 2, des Welteren einen Winkelvarllerschritt zum Ändarn eines Winkels (θ) zwischen der Oberfläche des Substrats (12) und der Oberfläche des Zielmaterials (14) durch Variieren einer relativen Position des Substrats (12) In Bezug auf das Zielmaterial (14) umfassend.

8. Filmaufbringungsverfahren nach Anspruch 1 oder 2, wobei der Film einen Oxld-Supraleiter umfaßt.

9. Filmaufbringungsverfahren nach Anspruch 8, wobei der Oxid-Supraleiter eine Art umfaßt, die aus der Gruppe ausgewählt Ist, die besteht aus einem Oxid-Supraleiter auf Basis von RE123 und einem Oxid-Supraleiter auf der Basis von Wismut.

10. Filmaufbringungsverfahren nach Anspruch 1 oder 2, des weiteren einen Schritt des Ausbildens eines Oxid-Supraleiters auf dem Film umfassend, wobei der Film ein Zwischenfilm ist, der zwischen dem Substrat (12) und dem Oxid-Supraleiter positioniert ist.

11. Filmaufbringungsverfahren nach Anspruch 10, wobei der Film mindestens eine Art umfaßt, die aus der Gruppe ausgewählt Ist, die aus mit Yttriumoxid stabilisiertem Zirconiumdioxid, Ceroxid, Magnesiumoxid und Strontiumtitanat besteht.

12. Filmaufbringungsverfahren nach Anspruch 1 oder 2, wobei ein das Substrat (12) bildendes Material mindestens eines umfaßt, das aus der Gruppe ausgewählt ist, die aus Saphir, Lanthanaluminat, Strontiumtitanat und Lanthan-Strontium-Aluminium-Tltanoxid (LSAT) besteht.

13. Filmaufbringungsvorrlchtung (1) zur Ausbildung eines dünnen Films durch Streuen eines Abscheidungsmaterials von einer Oberfläche eines Zielmaterials (14) und zum Aufbringen des gestreuten Abscheidungsmaterials auf eine Oberfläche eines Substrats (12), umfassend:
- ein Variiermittel (4-6; 21) zum Variieren eines Winkels der Oberfläche des Substrats (12) zu der Oberfläche des Zielmaterials (14);
- ein Bewegungsmittel (9; 23) zum Bewegen einer relativen Position des Substrats (12) in Bezug auf das Zielmaterial (14) in zu der Oberfläche des Substrats (12) annähernd parallelen Richtung,
**dadurch gekennzeichnet, daß**
- das Bewegungsmittel (9; 23) die Position das Substrats relativ zu dem Zieimaterial (14) in der Richtung der Breite (W) und der Länge (L) des Substrats (12) bewegen kann.

14. Fllmaufbringungsvorrichtung nach Anspruch 13, wobel das Varliermittel (4-6, 9-11;21)
- ein bogenförmiges Führungselement (4) und
- ein Substrathalteelement (11) umfaßt, das bewegbar an dem Führungselement (4) befestigt Ist, um das Substrat (12) zu halten.

15. Filmaufbringungsvorrichtung (1) nach Anspruch 13, des Weiteren ein Bestrahlungsmittel (18) zum Bestrahlen der Oberfläche des Zielmaterials (14) mit Energlestrahlen (16) umfassend, um das Abscheidungsmaterial von der Oberfläche des Zielmaterials (14) zu streuen.

## Revendications

1. Procédé de déposition de film destiné à former un film en diffusant un matériau à déposer à partir d'une surface d'un matériau cible (14) et en déposant le matériau à déposer diffusé sur une surface d'un substrat (12), comprenant :
- une étape consistant à disposer ledit substrat (12) et ledit matériau cible (14) de telle manière que la surface dudit substrat (12) forme un angle par rapport à la surface du matériau cible (14) ; et
- une étape de déposition consistant à former ledit film sur ledit substrat (12) de telle manière qu'une superficie d'une surface dudit film est continuellement augmentée dans une direction bidimensionnelle, pendant qu'une position relative dudit substrat (12) par rapport audit matériau cible (14) est déplacée ;
**caractérisé en ce que**, dans ladite étape de déposition,
- une direction de déplacement, dans laquelle une position relative dudit substrat (12) par rapport audit matériau cible (14) est déplacée, est sensiblement parallèle à la surface dudit substrat (12) ; et
- la région de déposition (27) dans laquelle la surface du substrat est pourvue d'un film est une portion de la surface totale du substrat (12) et ladite région (27) se déplace, progressivement, d'une extrémité à l'autre extrémité dans le sens de la largeur W dudit substrat (12) et simultanément d'une extrémité à l'autre extrémité dans le sens de la longueur L dudit substrat (12).

2. Procédé de déposition de film destiné à former un film en diffusant un matériau à déposer à partir d'une surface d'un matériau cible (14) et en déposant le matériau à déposer diffusé sur une surface d'un substrat (12), comprenant :
- une étape consistant à disposer ledit substrat (12) et ledit matériau cible (14) de telle manière que la surface dudit substrat (12) forme un angle par rapport à la surface du matériau cible (14) ; et
- une étape de déposition consistant à former ledit film sur ledit substrat (12) de telle manière qu'une superficie d'une surface dudit film est continuellement augmentée dans une direction bidimensionnelle, pendant qu'une position relative dudit substrat (12) par rapport audit matériau cible (14) est déplacée ;
**caractérisé en ce que**, dans ladite étape de déposition,
- une direction de déplacement, dans laquelle une position relative dudit substrat (12) par rapport audit matériau cible (14) est déplacée, est sensiblement parallèle à la surface dudit substrat (12) ;
- la région de déposition (27) dans laquelle la surface du substrat est pourvue d'un film est une portion de la surface totale du substrat (12) et ladite région (27) :
(a) se déplace d'une extrémité à l'autre extrémité dans le sens de la largeur W dudit substrat (12) ;
(b) puis se déplace dans le sens de la longueur L dudit substrat (12) ;
(c) se déplace, en outre, depuis ladite autre extrémité vers ladite extrémité dans le sens de la largeur W dudit substrat (12) ;
(d) puis se déplace dans le sens de la longueur L dudit substrat (12) ; et
e) les étapes (a) à (d) sont répétées.

3. Procédé de déposition de film selon la revendication 1 ou 2, dans lequel un angle (θ) entre la surface dudit substrat (12) et la surface dudit matériau cible (14) est supérieur à 0°C et est égal ou inférieur à 90°C.

4. Procédé de déposition de film selon la revendication 1 ou 2, dans lequel des rayons énergétiques (16) sont appliqués à la surface dudit matériau cible (14) afin de diffuser le matériau à déposer à partir de la surface dudit matériau cible (14).

5. Procédé de déposition selon la revendication 4, dans lequel un angle (θ_{LT}) entre un trajet (25) desdits rayons énergiques (16) et la surface dudit matériau cible (14) est inférieur à un angle (θ) entre la surface dudit substrat (12) et la surface dudit matériau cible (14).

6. Procédé de déposition de film selon la revendication 4, dans lequel un trajet (25) desdits rayons énergétiques (16) est sensiblement parallèle à la surface dudit substrat (12).

7. Procédé de déposition de film selon la revendication 1 ou 2 comprenant, en outre, une étape de variation d'angle consistant à modifier un angle (θ) entre la surface dudit substrat (12) et la surface dudit matériau cible (14) en faisant varier une position relative dudit substrat (12) par rapport audit matériau cible (14).

8. Procédé de déposition de film selon la revendication 1 ou 2, dans lequel ledit film comprend un supraconducteur de type oxyde.

9. Procédé de déposition de film selon la revendication 8, dans lequel ledit supraconducteur de type oxyde comprend un matériau choisi dans le groupe d'un supraconducteur de type oxyde à base de RE123 et un supraconducteur de type oxyde à base de bismuth.

10. Procédé de déposition de film selon la revendication 1 ou 2 comprenant, en outre, une étape consistant à former un supraconducteur de type oxyde sur ledit film, dans laquelle ledit film est un film intermédiaire positionné entre ledit substrat (12) et ledit supraconducteur de type oxyde.

11. Procédé de déposition de film selon la revendication 10, dans lequel ledit film comprend au moins un matériau choisi dans le groupe composé d'une zircone stabilisée par un oxyde d'yttrium, d'un oxyde de cérium, d'un oxyde de magnésium, et d'un titanate de strontlum.

12. Procédé de déposition de film selon la revendication 1 ou 2, dans lequel un matériau formant ledit substrat (12) comprend au moins un matériau choisi dans le groupe composé du saphir, de l'aluminate de lanthane, du titanate de strontium, et d'un oxyde mixte de lanthane-strontium-aluminium-titane (LSAT).

13. Appareil filmogène (1) destiné à former un film mince en diffusant un matériau à déposer à partir d'une surface d'un matériau cible (14) et en déposant le matériau à déposer diffusé sur une surface d'un substrat (12) comprenant :
- un moyen de variation (4-6; 21) pour faire varier un angle de la surface dudit substrat (12) par rapport à la surface dudit matériau cible (14) ;
- un moyen de déplacement (9; 23) pour déplacer une position relative dudit substrat (12) par rapport audit matériau cible (14) dans une direction sensiblement parallèle à la surface dudit substrat (12) ;
**caractérisé en ce que**
- ledit moyen de déplacement (9; 23) est capable de déplacer la position du substrat par rapport au matériau cible (14) dans les sens de la largeur (W) et de la longueur (L) dudit substrat (12).

14. Appareil filmogène selon la revendication 13, dans lequel ledit moyen de variation (4-6, 8-11, 21) comprend :
- un élément de guidage en forme d'arc (4) et
- un porte-substrat (11) monté de manière mobile sur ledit élément de guidage (4) pour supporter ledit substrat (12).

15. Appareil filmogène (1) selon la revendication 13 comprenant, en outre, un moyen d'irradiation (18) pour irradier la surface dudit matériau cible (14) avec des rayons énergétiques (16) afin de diffuser ledit matériau à déposer à partir de la surface dudit matériau cible (14).
